# EUROPEAN PATENT APPLICATION

(11) **EP 4 478 523 A1**
(43) Date of publication of application: **18.12.2024**
(21) Application number: 23752622.3
(22) Date of filing: 18.01.2023
(51) Int. Cl.: H01M 50/569, H01M 50/296

(54) **VOLTAGE DETECTION DEVICE AND BATTERY MODULE**

(30) Priority: 10.02.2022 JP 2022019515
(71) Applicant: AESC Japan Ltd., Kanagawa, 2520012 (JP)
(72) Inventor: IZAWA, Takami, Zama-shi, Kanagawa 252-0012 (JP); NAKAI, Masayuki, Zama-shi, Kanagawa 252-0012 (JP); YANAGIHARA, Yasuhiro, Zama-shi, Kanagawa 252-0012 (JP); AMAGAI, Ryuichi, Zama-shi, Kanagawa 252-0012 (JP); CUI, Liping, Zama-shi, Kanagawa 252-0012 (JP)
(74) Representative: Mathys & Squire
(86) International application number: PCT/JP2023/001279
(87) International publication number: WO 2023/153153

(57) **Abstract**

A voltage detection device (300) includes: a voltage detection portion (310) to detects a voltage of at least one battery cell (100) ; a right bus bar (340) at least partially to electrically connect the at least one battery cell (100) to an external apparatus; and a right attachment body (360) to which the right bus bar (340) is attached. The right attachment body (360) has a heat resistance.

## Description

### TECHNICAL FIELD

The present invention relates to a voltage detection device and a battery module.

### BACKGROUND ART

A battery module such as a lithium-ion secondary battery includes a plurality of staked battery cells. In such a battery module, a plurality of battery cells is electrically connected to each other by a positive lead and an negative lead drawn from the battery cell. A plurality of battery cells connected in parallel may be connected in series with a plurality of other battery cells connected in parallel.

Patent Document 1 describes one example of a battery module. In this example, a positive lead and an negative lead of each battery cell are electrically connected to each other via a bus bar.

Patent Document 2 describes one example of a method of manufacturing a battery module. In this example, a positive lead of a single battery cell and an negative lead of another single battery cell are bonded to each other by ultrasonic bonding. A lead portion is folded back between different battery cells.

### RELATED DOCUMENT

### PATENT DOCUMENT

Patent Document 1: Japanese Patent Application Publication (Translation of PCT Application) No. 2020-524375
Patent Document 2: Japanese Patent Application Publication No. 2018-152223

### SUMMARY OF INVENTION

### TECHNICAL PROBLEM

For example, as described in Patent Document 2, a lead portion may be folded back between different battery cells. In this case, a voltage detection device including a voltage detection portion connected to each lead portion of each battery cell may be used to detect a voltage of each battery cell. The voltage detection device may include a bus bar to electrically connect a plurality of battery cells to an external apparatus. The bus bar, however, may generate heat at a relatively high temperature in a certain condition that a large current flows through the bus bar, and the like, for example. Thus, the voltage detection device may be damaged due to heat generation by the bus bar.

One example of an object of the present invention is to suppress damage to a voltage detection device due to heat generation by a bus bar. Another object of the present invention will become apparent from the description of the present specification.

### SOLUTION TO PROBLEM

One aspect of the present invention is a voltage detection device including:
a voltage detection portion to detect a voltage of at least one battery cell;
a bus bar at least partially to electrically connect the at least one battery cell to an external apparatus; and
a first attachment body to which the bus bar is attached, wherein
the first attachment body has a heat resistance.

Another aspect of the present invention is a battery module including:
the voltage detection device; and
the at least one battery cell.

### ADVANTAGEOUS EFFECTS OF INVENTION

According to the above-described aspects of the present invention, damage to a voltage detection device due to heat generation by a bus bar can be suppressed.

### BRIEF DESCRIPTION OF THE DRAWINGS

[Fig. 1] A front exploded perspective view of a battery module according to an embodiment.
[Fig. 2] A side view of a part of a plurality of battery cells according to the embodiment.

### DESCRIPTION OF EMBODIMENTS

Hereinafter, embodiments and variants of the present invention will be described by using drawings. In all drawings, a similar component has a similar reference sign, and description thereof will be appropriately omitted.

In the present specification, an ordinal numeral such as "first", "second", and "third" is provided for simply distinguishing a configuration provided with a similar name unless otherwise specified and does not indicate a specific characteristic (for example, an order or importance) of a configuration.

In the present specification, A and B substantially equal means not only that A and B are strictly equal, but also means that, for example, A is equal to or more than 90% and equal to or less than 110% of B, or B is equal to or more than 90% and equal to or less than 110% of A.

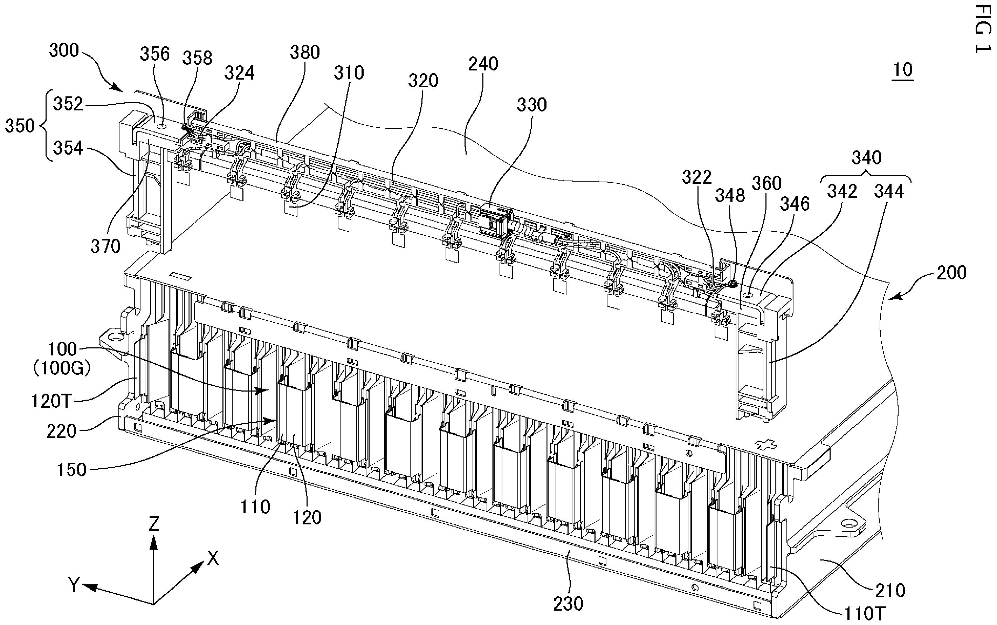

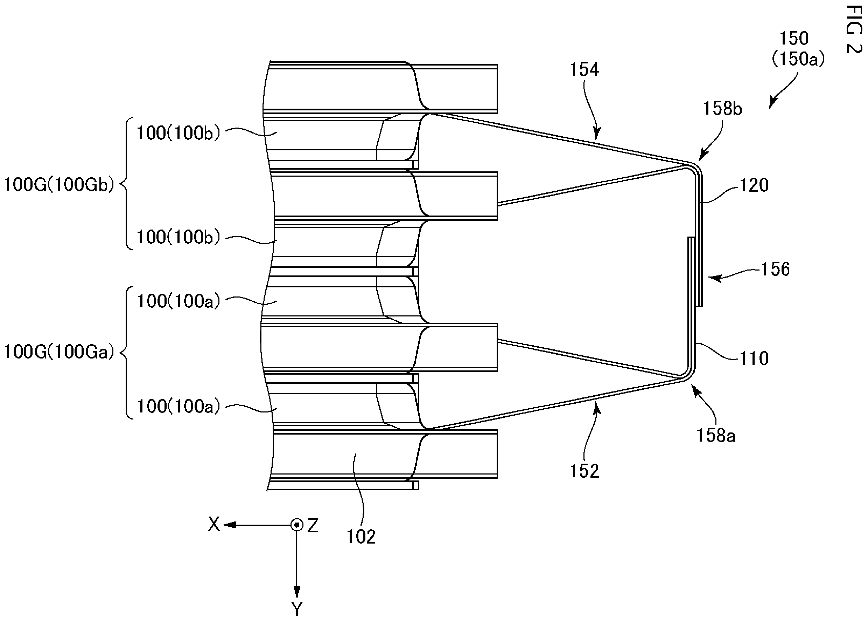

Fig. 1 is a front exploded perspective view of a battery module 10 according to an embodiment. Fig. 2 is a side view of a part of a plurality of battery cells 100 according to the embodiment.

In Figs. 1 and 2, a first direction X is a direction parallel to a long-side direction of the battery cell 100. A second direction Y is orthogonal to the first direction X and is a direction parallel to a thickness direction of the battery cell 100. A third direction Z is orthogonal to both of the first direction X and the second direction Y and is a direction parallel to a short-side direction of the battery cell 100. An arrow indicating the first direction X, the second direction Y, or the third direction Z indicates a direction from a base end to a tip end of the arrow is a positive direction of the direction indicated by the arrow and a direction from a tip end to a base end of the arrow is a negative direction of the direction indicated by the arrow. A white circle with a black dot indicating the third direction Z indicates a direction from the front to the back of the paper plane is a positive direction of the third direction Z and a direction from the back to the front of the paper plane is a negative direction of the third direction Z.

In Figs. 1 and 2, a positive direction of the first direction X is parallel to a direction from the front to the rear of the battery module 10 and a negative direction of the first direction X is a direction from the rear to the front of the battery module 10. A positive direction of the second direction Y is parallel to a direction from the right to the left when viewed from the front of the battery module 10 and a negative direction of the second direction Y is parallel to a direction from the left to the right when viewed from the front of the battery module 10. A positive direction of the third direction Z is parallel to a direction from the bottom to the top in a vertical direction and a negative direction of the third direction Z is parallel to a direction from the top to the bottom in the vertical direction. A relationship among the first direction X, the second direction Y, the third direction Z, and the vertical direction is not limited to the example described above. The relationship among the first direction X, the second direction Y, the third direction Z, and the vertical direction varies according to an arrangement of the battery module 10. For example, the battery module 10 may be disposed such that the first direction X or the second direction Y is parallel to the vertical direction.

The battery module 10 will be described with reference to Figs. 1 and 2.

The battery module 10 includes the plurality of battery cells 100, a housing body 200, and a voltage detection device 300. The voltage detection device 300 includes a plurality of voltage detection portions 310, a plurality of voltage detection lines 320, a first wiring 322, a second wiring 324, a connector 330, a right bus bar 340, a left bus bar 350, a right attachment body 360, a left attachment body 370, and a central attachment body 380. The battery module 10 also includes an unillustrated voltage detection device on the positive direction side of the first direction X of the plurality of cell groups 100G stacked in the second direction Y, similarly to the negative direction side of the first direction X of the plurality of cell groups 100G stacked in the second direction Y.

The plurality of battery cells 100 are stacked in the second direction Y. Each of the battery cells 100 includes an exterior material 102. Each of the battery cells 100 is provided with a positive lead 110 and an negative lead 120.

The exterior material 102 houses a positive electrode, a negative electrode, and a separator that are not illustrated together with an electrolytic solution that is not illustrated. As one example, the positive electrode, the negative electrode, and the separator are stacked in the second direction Y inside the exterior material 102. Alternatively, the positive electrode, the negative electrode, and the separator may be wound inside the exterior material 102.

The positive lead 110 is drawn from one end of the exterior material 102 on a positive direction side and a negative direction side of the first direction X. The positive lead 110 is electrically connected to the positive electrode inside the exterior material 102. As one example, the positive lead 110 is formed of a metal such as aluminum.

The negative lead 120 is drawn from another end of the exterior material 102 on the positive direction side and the negative direction side of the first direction X. The negative lead 120 is electrically connected to the negative electrode inside the exterior material 102. As one example, the negative lead 120 is formed of a metal different from the metal forming the positive lead 110, such as copper.

The plurality of battery cells 100 stacked in the second direction Y include a plurality of cell groups 100G stacked in the second direction Y. Each of the cell groups 100G includes the plurality of battery cells 100 adjacent to each other in the second direction Y and connected in parallel. The plurality of cell groups 100G are connected in series from the cell group 100G located at an end portion of the plurality of cell groups 100G on a negative direction side of the second direction Y to the cell group 100G located at an end portion of the plurality of cell groups 100G on a positive direction side of the second direction Y.

Details of the cell group 100G will be described by using Fig. 2. Fig. 2 illustrates an end portion of a first cell group 100Ga and a second cell group 100Gb of the plurality of cell groups 100G on the negative direction side of the first direction X.

The first cell group 100Ga includes the plurality of battery cells 100, i.e., a plurality of first battery cells 100a adjacent to each other in the second direction Y and connected in parallel. The second cell group 100Gb includes the plurality of battery cells 100, i.e., a plurality of second battery cells 100b adjacent to each other in the second direction Y and connected in parallel.

The first cell group 100Ga is provided with a plurality of the positive leads 110 being bundled together. The second cell group 100Gb is provided with a plurality of the negative leads 120 being bundled together. The plurality of positive leads 110 of the first cell group 100Ga and the plurality of positive leads 110 that are not illustrated in Fig. 2 of the second cell group 100Gb face opposite sides with respect to the first direction X. The plurality of negative leads 120 that are not illustrated in Fig. 2 of the first cell group 100Ga and the plurality of negative leads 120 of the second cell group 100Gb face opposite sides with respect to the first direction X.

At least a part, specifically, a tip portion of the plurality of positive leads 110 of the first cell group 100Ga and at least a part, specifically, a tip portion of the plurality of negative leads 120 of the second cell group 100Gb are bonded to each other. The plurality of positive leads 110 of the first cell group 100Ga and the plurality of negative leads 120 of the second cell group 100Gb are folded back from one of the first cell group 100Ga and the second cell group 100Gb to the first cell group 100Ga and the second cell group 100Gb via the at least a part of the plurality of positive leads 110 of the first cell group 100Ga and the at least a part of the plurality of negative leads 120 of the second cell group 100Gb. Accordingly, the first cell group 100Ga and the second cell group 100Gb can be electrically connected to each other without a conductive member such as a bus bar being interposed therebetween. In this case, a structure for connecting the first cell group 100Ga and the second cell group 100Gb in series can be simplified as compared to a case where a conductive member such as a bus bar is used.

A lead portion 150 including the plurality of positive leads 110 of the first cell group 100Ga and the plurality of negative leads 120 of the second cell group 100Gb includes a first region 152, a second region 154, and a third region 156. The lead portion 150 is folded back between the different battery cells 100, specifically, between the first cell group 100Ga and the second cell group 100Gb. The first region 152 is a region where a distance in the second direction Y between the plurality of positive leads 110 of the first cell group 100Ga decreases with a greater distance from the first cell group 100Ga. The second region 154 is a region where a distance in the second direction Y between the plurality of negative leads 120 of the second cell group 100Gb decreases with a greater distance from the second cell group 100Gb. The third region 156 is a region located between the first region 152 and the second region 154 and where the plurality of positive leads 110 of the first cell group 100Ga and the plurality of bundled negative leads 120 are bonded to each other.

As illustrated in Fig. 2, lengths of two positive leads 110 located at both ends in the second direction Y of the plurality of positive leads 110 of the first cell group 100Ga from the exterior material 102 to a first bent portion 158a between the first region 152 and the third region 156 are substantially equal. In this case, occurrence of bending of one of the above-described two positive leads 110 can be suppressed as compared to a case where the above-described lengths of the above-described two positive leads 110 are different from each other. The above-described lengths of the above-described two positive leads 110 may be different from each other.

As illustrated in Fig. 2, lengths of two negative leads 120 located at both ends in the second direction Y of the plurality of negative leads 120 of the second cell group 100Gb from the exterior material 102 to a second bent portion 158b between the second region 154 and the third region 156 are substantially equal. In this case, occurrence of bending of one of the above-described two negative leads 120 can be suppressed as compared to a case where the above-described lengths of the above-described two negative leads 120 are different from each other. The above-described lengths of the above-described two negative leads 120 may be different from each other.

As illustrated in Fig. 2, the third region 156 between the first bent portion 158a and the second bent portion 158b is flat in parallel with the second direction Y and the third direction Z. In this case, the voltage detection portion 310 described below can be easily bonded to the third region 156 as compared to a case where the third region 156 is non-flat, for example being curved. The third region 156 may be non-flat, for example being curved.

The battery module 10 will be described with reference to Figs. 1 to 2 again.

As illustrated in Fig. 1, in a region where the plurality of positive leads 110 and the plurality of negative leads 120 of each lead portion 150 located on the negative direction side of the first direction X of the plurality of cell groups 100G stacked in the second direction Y are bonded to each other, the plurality of negative leads 120 are located on the negative direction side of the first direction X from the plurality of positive leads 110. A structure of each lead portion 150, however, is not limited to the example illustrated in Fig. 1. The plurality of lead portions 150 are also provided on the positive direction side of the first direction X of the plurality of cell groups 100G stacked in the second direction Y, similarly to the negative direction side of the first direction X of the plurality of cell groups 100G stacked in the second direction Y.

The housing body 200 houses the plurality of cell groups 100G stacked in the second direction Y. The housing body 200 includes a right cover member 210, a left cover member 220, a lower cover member 230, and an upper cover member 240. The right cover member 210 covers the negative direction side of the second direction Y of the plurality of cell groups 100G stacked in the second direction Y. The left cover member 220 covers the positive direction side of the second direction Y of the plurality of cell groups 100G stacked in the second direction Y. The lower cover member 230 covers the negative direction side of the third direction Z of the plurality of cell groups 100G stacked in the second direction Y. The upper cover member 240 covers the positive direction side of the third direction Z of the plurality of cell groups 100G stacked in the second direction Y. The housing body 200 includes an unillustrated front cover member that covers the negative direction side of the first direction X of the plurality of cell groups 100G stacked in the second direction Y and the voltage detection device 300. Furthermore, the housing body 200 includes an unillustrated rear cover member that covers the positive direction side of the first direction X of the plurality of cell groups 100G stacked in the second direction Y and an unillustrated voltage detection device provided on the positive direction side of the first direction X of the plurality of cell groups 100G stacked in the second direction Y. In the example illustrated in Fig. 1, the front cover member is removed.

Each of the plurality of voltage detection portions 310 is provided for each of the plurality of lead portions 150. Each of the plurality of voltage detection portions 310 detects a voltage of each of the plurality of lead portions 150. Each of the voltage detection portions 310 is electrically connected to at least one of the plurality of positive leads 110 and the plurality of negative leads 120 in each of the lead portions 150. Each of the voltage detection portions 310 is bonded to the plurality of positive leads 110 and the plurality of negative leads 120 in the lead portion 150 by laser welding, for example.

The voltage detection portion 310 is provided on a flat portion of the lead portion 150 parallel to the second direction Y and the third direction Z. In this case, the voltage detection portion 310 can be easily bonded to the lead portion 150 as compared to a case where the voltage detection portion 310 is provided on a non-flat portion such as a bent portion of the lead portion 150 and a case where the entire lead portion 150 is curved.

The voltage detection portion 310 may be movable in at least one of a direction toward the lead portion 150 and a direction away from the lead portion 150. In this case, the voltage detection portion 310 can be disposed in an appropriate position in the first direction X with respect to the lead portion 150 by moving the voltage detection portion 310 in the first direction X.

In one example, the voltage detection portion 310 includes the same material as a material included in a portion of the lead portion 150 in contact with the voltage detection portion 310, i.e., the negative lead 120. In this example, the material included in the voltage detection portion 310 can be easily bonded to the negative lead 120 as compared to a case where a material included in the voltage detection portion 310 and a material included in the negative lead 120 are different.

One end of each of the plurality of voltage detection lines 320 is electrically connected to each of the plurality of voltage detection portions 310. Another end of the plurality of voltage detection lines 320 is electrically connected to the connector 330. Accordingly, the plurality of voltage detection portions 310 is electrically connected to the connector 330 via the plurality of voltage detection lines 320.

The right bus bar 340 includes a first extension body 342 and a second extension body 344. Each of the first extension body 342 and the second extension body 344 is formed of, for example, copper or aluminum. The first extension body 342 and the second extension body 344 extend in directions different from each other. Specifically, the first extension body 342 extends substantially in parallel with the second direction Y. The second extension body 344 extends substantially in parallel with the third direction Z. An end portion of the first extension body 342 on the negative direction side of the second direction Y and an end portion of the second extension body 344 on the positive direction side of the third direction Z cross each other substantially at a right angle. Thus, the right bus bar 340 has substantially an L shape when viewed from the first direction X.

The first extension body 342 functions as a terminal for electrically connecting the plurality of cell groups 100G to an unillustrated external apparatus. Specifically, the second extension body 344 is electrically connected to a terminal positive lead 110T. The terminal positive lead 110T is the positive lead 110 drawn to the negative direction side of the first direction X of the cell group 100G located at an end portion on the negative direction side of the second direction Y of the plurality of cell groups 100G. A first fastening hole 346 is provided in the first extension body 342. An unillustrated fixture for fixing an unillustrated external apparatus is fixed to the first fastening hole 346.

A direction in which the terminal positive lead 110T is drawn can be changed by a total number of the plurality of cell groups 100G stacked in the second direction Y. For example, the terminal positive lead 110T may be the positive lead 110 drawn to the positive direction side of the first direction X of the cell group 100G located at the end portion on the negative direction side of the second direction Y of the plurality of cell groups 100G. In this example, similarly to the terminal positive lead 110T, the right bus bar 340 is provided on the positive direction side of the first direction X of the plurality of cell groups 100G.

The first extension body 342 is electrically connected to the connector 330 via the first wiring 322. Specifically, one end of the first wiring 322 is attached to the first extension body 342 by a first fitting 348 provided on the first extension body 342. In the embodiment, the first fitting 348 is a screw. The first fitting 348 attaches one end of the first wiring 322 to the first extension body 342 and also attaches the first extension body 342 to the right attachment body 360. Another end of the first wiring 322 is electrically connected to the connector 330. The first wiring 322 functions as a voltage detection line of the right bus bar 340.

The left bus bar 350 includes a third extension body 352 and a fourth extension body 354. Each of the third extension body 352 and the fourth extension body 354 is formed of, for example, copper or aluminum. The third extension body 352 and the fourth extension body 354 extend in directions different from each other. Specifically, the third extension body 352 extends substantially in parallel with the second direction Y. The fourth extension body 354 extends substantially in parallel with the third direction Z. An end portion of the third extension body 352 on the positive direction side of the second direction Y and an end portion of the fourth extension body 354 on the positive direction side of the third direction Z cross each other substantially at a right angle. Thus, the left bus bar 350 has substantially an L shape when viewed from the first direction X.

The third extension body 352 functions as a terminal for electrically connecting the plurality of cell groups 100G to an unillustrated external apparatus. Specifically, the fourth extension body 354 is electrically connected to a terminal negative lead 120T. The terminal negative lead 120T is the negative lead 120 drawn to the negative direction side of the first direction X of the cell group 100G located at an end portion on the positive direction side of the second direction Y of the plurality of cell groups 100G. A second fastening hole 356 is provided in the third extension body 352. An unillustrated fixture for fixing an unillustrated external apparatus is fixed to the second fastening hole 356.

A direction in which the terminal negative lead 120T is drawn can be changed by a total number of the plurality of cell groups 100G stacked in the second direction Y. For example, the terminal negative lead 120T may be the negative lead 120 drawn to the positive direction side of the first direction X of the cell group 100G located at the end portion on the positive direction side of the second direction Y of the plurality of cell groups 100G. In this example, similarly to the terminal negative lead 120T, the left bus bar 350 is provided on the positive direction side of the first direction X of the plurality of cell groups 100G.

The third extension body 352 is electrically connected to the connector 330 via the second wiring 324. Specifically, one end of the second wiring 324 is attached to the third extension body 352 by a second fitting 358 provided on the third extension body 352. In the embodiment, the second fitting 358 is a screw. The second fitting 358 attaches one end of the second wiring 324 to the third extension body 352 and also attaches the third extension body 352 to the left attachment body 370. Another end of the second wiring 324 is electrically connected to the connector 330. The second wiring 324 functions as a voltage detection line of the left bus bar 350.

The right attachment body 360 is attached to a right cover member 210. The right bus bar 340 is attached to the right attachment body 360. Specifically, at least a part of the second extension body 344 is inserted through the right attachment body 360 in the third direction Z. As described above, the first extension body 342 is attached to the right attachment body 360 by the first fitting 348. However, an attachment method of the right bus bar 340 to the right attachment body 360 is not limited to this example.

The left attachment body 370 is attached to a left cover member 220. The left bus bar 350 is attached to the left attachment body 370. Specifically, at least a part of the fourth extension body 354 is inserted through the left attachment body 370 in the third direction Z. As described above, the third extension body 352 is attached to the left attachment body 370 by the second fitting 358. However, an attachment method of the left bus bar 350 to the left attachment body 370 is not limited to this example.

The central attachment body 380 is attached to an upper cover member 240. The central attachment body 380 extends substantially in parallel with the second direction Y. An end portion of the central attachment body 380 on the negative direction side of the second direction Y is connected to an end portion of the right attachment body 360 on the positive direction side of the third direction Z.
An end portion of the central attachment body 380 on the positive direction side of the second direction Y is connected to an end portion of the left attachment body 370 on the positive direction side of the third direction Z.

The plurality of voltage detection portions 310, the plurality of voltage detection lines 320, the first wiring 322, the second wiring 324, and the connector 330 are attached to the central attachment body 380. Specifically, an end portion of each of the voltage detection portions 310 on the positive direction side of the third direction Z is held by the central attachment body 380. The plurality of voltage detection lines 320, the first wiring 322, and the second wiring 324 are provided along a groove provided on the negative direction side of the first direction X of the central attachment body 380. The connector 330 is provided substantially at the center of the second direction Y of the central attachment body 380. However, an attachment method of the plurality of voltage detection portions 310, the plurality of voltage detection lines 320, the first wiring 322, the second wiring 324, and the connector 330 to the central attachment body 380 is not limited to this example.

The right attachment body 360 has a heat resistance. Specifically, the right attachment body 360 includes a heat resistant material. The heat resistant material is preferably a material having a melting point higher than that of polypropylene (PP) and is preferably a material having a melting point equal to or higher than 200°C. Examples of the heat resistant material include polybutylene terephthalate, modified polyphenylene ether, and the like. The right attachment body 360 may include a single heat resistant material exemplified herein or may include a plurality of kinds of heat resistant materials exemplified herein. A large current may flow through the right bus bar 340. The right bus bar 340 may generate heat at a relatively high temperature in a certain condition that a large current flows through the right bus bar 340, and the like. In the embodiment, however, damage to the right attachment body 360 due to heat generation by the right bus bar 340 can be suppressed as compared to a case where the right attachment body 360 does not have a heat resistance. As described above, a part of the right bus bar 340 functions as a terminal for electrically connecting the plurality of cell groups 100G to an unillustrated external apparatus. Thus, the right bus bar 340 and a terminal of the unillustrated external apparatus are connected by an unillustrated fastening member such as a screw provided in the first fastening hole 346. At this time, a relatively great load may be applied to the right attachment body 360 due to torque when the terminal of the unillustrated external apparatus is attached to the right bus bar 340. For that reason, balancing a heat resistance and strength may be required of the right attachment body 360. Thus, the heat resistance and strength of the right attachment body 360 can be balanced by inclusion of a fiber material such as fiberglass in the heat resistant material of the right attachment body 360.

The left attachment body 370 has a heat resistance. Specifically, the left attachment body 370 includes a heat resistant material. Examples of the heat resistant material of the left attachment body 370 include materials similar to the materials exemplified in the description of the right attachment body 360. Similarly to the right bus bar 340, a large current may flow through the left bus bar 350. The left bus bar 350 may generate heat at a relatively high temperature in a certain condition that a large current flows through the left bus bar 350, and the like. In the embodiment, however, damage to the left attachment body 370 due to heat generation by the left bus bar 350 can be suppressed as compared to a case where the left attachment body 370 does not have a heat resistance. Similarly to the heat resistant material included in the right attachment body 360, the heat resistant material included in the left attachment body 370 may include a fiber material.

A heat resistance of the central attachment body 380 may be lower than at least one of a heat resistance of the right attachment body 360 and a heat resistance of the left attachment body 370. This is because the plurality of voltage detection portions 310, the plurality of voltage detection lines 320, the first wiring 322, the second wiring 324, and the connector 330 attached to the central attachment body 380 are less likely to generate heat at a high temperature than the right bus bar 340 and the left bus bar 350. Examples of a material used for the central attachment body 380 includes polypropylene (PP) and the like. A cost of a material having a relatively high heat resistance is relatively high. Accordingly, a cost of the central attachment body 380 can be reduced when a heat resistance of the central attachment body 380 is lower than at least one of the heat resistance of the right attachment body 360 and the heat resistance of the left attachment body 370 as compared where a heat resistance of the central attachment body 380 is equal to or higher than both of the heat resistance of the right attachment body 360 and the heat resistance of the left attachment body 370. The central attachment body 380 however may have a heat resistance similarly to the right attachment body 360 and the left attachment body 370.

As described above, whether the terminal positive lead 110T and the terminal negative lead 120T are drawn on the positive direction side of the first direction X or the negative direction side of the first direction X is changed by a total number of the plurality of cell groups 100G stacked in the second direction Y. Accordingly, there is a case where, for example, the terminal positive lead 110T and the right bus bar 340 are provided on the negative direction side of the first direction X and the negative direction side of the second direction Y of the plurality of cell groups 100G and the terminal negative lead 120T and the left bus bar 350 are provided on the positive direction side of the first direction X and the positive direction side of the second direction Y of the plurality of cell groups 100G. In this example, similarly to the terminal positive lead 110T and the right bus bar 340, the right attachment body 360 is provided on the negative direction side of the first direction X and the negative direction side of the second direction Y of the plurality of cell groups 100G, and, similarly to the terminal negative lead 120T and the left bus bar 350, the left attachment body 370 is provided on the positive direction side of the first direction X and the positive direction side of the second direction Y of the plurality of cell groups 100G.

While the embodiments and the variants of the present invention have been described with reference to the drawings, the embodiments and the variants are only exemplification of the present invention, and various configurations other than the above-described embodiments and variants can also be employed.

For example, in the embodiment, two battery cells 100 connected in parallel are connected in series with other two battery cells 100 connected in parallel. However, three or more battery cells 100 connected in parallel may be connected in series with other three or more battery cells 100 connected in parallel.

In the embodiment, the voltage detection device 300 is used for detecting a voltage of the lead portion 150 including the plurality of positive leads 110 and the plurality of negative leads 120. However, the voltage detection device 300 may also be used for detecting a voltage of the lead portion 150 including a single positive lead 110 and a single negative lead 120.

This application claims priority based on Japanese patent application No. 2022-019515, filed on February 10, 2022, the disclosure of which is incorporated herein in its entirety by reference.

### REFERENCE SIGNS LIST

- 10: Battery module
- 100: Battery cell
- 100G: Cell group
- 100Ga: First cell group
- 100Gb: Second cell group
- 100a: First battery cell
- 100b: Second battery cell
- 102: Exterior material
- 110: Positive lead
- 110T: Terminal positive lead
- 120: Negative lead
- 120T: Terminal negative lead
- 150: Lead portion
- 152: First region
- 154: Second region
- 156: Third region
- 158a: First bent portion
- 158b: Second bent portion
- 200: Housing body
- 210: Right cover member
- 220: Left cover member
- 230: Lower cover member
- 240: Upper cover member
- 300: Voltage detection device
- 310: Voltage detection portion
- 320: Voltage detection line
- 322: First wiring
- 324: Second wiring
- 330: Connector
- 340: Right bus bar
- 342: First extension body
- 344: Second extension body
- 346: First fastening hole
- 348: First fitting
- 350: Left bus bar
- 352: Third extension body
- 354: Fourth extension body
- 356: Second fastening hole
- 358: Second fitting
- 360: Right attachment body
- 370: Left attachment body
- 380: Central attachment body
- X: First direction
- Y: Second direction
- Z: Third direction

## Claims

1. A voltage detection device comprising:
a voltage detection portion to detect a voltage of at least one battery cell;
a bus bar at least partially to electrically connect the at least one battery cell to an external apparatus; and
a first attachment body to which the bus bar is attached, wherein
the first attachment body has a heat resistance.

2. The voltage detection device according to claim 1, further comprising
a second attachment body to which the voltage detection portion is attached, wherein
a heat resistance of the second attachment body is lower than a heat resistance of the first attachment body.

3. The voltage detection device according to claim 2, wherein
the first attachment body contains at least one kind of polybutylene terephthalate and modified polyphenylene ether.

4. The voltage detection device according to claim 2 or 3, wherein
the second attachment body contains polypropylene.

5. The voltage detection device according to any one of claims 1 to 4, wherein
the first attachment body includes a fiber material.

6. A battery module comprising:
the voltage detection device according to any one of claims 1 to 5; and
the at least one battery cell.
